# FASCICULE DE BREVET EUROPEEN

(11) **EP 2 343 806 B1**
(45) Date de publication et mention de la délivrance du brevet: **18.07.2012**
(21) Numéro de dépôt: 10015368.3
(22) Date de dépôt: 07.12.2010
(51) Int. Cl.: H03K 19/003

(54) **Procédé et dispositif de contremesure pour protéger des données circulant dans un composant électronique**
Verfahren und Schaltkreis zur Gegenabwehr zum Schutz von Daten in einem elektronischen Schaltkreis
Method and circuit for countermeasures to protect data present in an electronic circuit

(30) Priorité: 24.12.2009 FR 0906352
(43) Date de publication de la demande: 13.07.2011
(73) Titulaire: STMicroelectronics Rousset SAS, 13790 Rousset (FR)
(72) Inventeur: Bancel, Frédéric, 13560 Senas (FR); Roquelaure, Philippe, 13320 Bouc Bel Air (FR)
(74) Mandataire: Marchand, André

(56) Documents cités:
- WO-A2-01/55821
- DE-B3- 10 344 647
- DE-B3-102005 037 355
- US-A- 6 133 761

## Description

La présente invention concerne un procédé de contremesure pour protéger des données sensibles circulant dans un composant électronique, contre des attaques visant à découvrir ces données. Elle concerne également un dispositif portable à microcircuit tel qu'une carte à puce, mettant en oeuvre le procédé.

Les données sensibles peuvent être notamment des clés de chiffrement ou de déchiffrement, et plus généralement des données cryptographiques utilisées ou élaborées lors de calculs cryptographiques, comme des données intermédiaires de tels calculs, et des identifiants qui doivent être conservés secrets.

Les dispositifs à microcircuit manipulant des données sensibles font parfois l'objet d'attaques visant à déterminer ces données. Parmi les attaques connues, les attaques de type SPA (Simple Power Analysis) ou DPA (Differential Power Analysis) consistent à mesurer des courants et des tensions entrants et sortants dans le microcircuit lors de l'exécution d'un programme par le microcircuit, dans le but d'en déduire des données protégées traitées ou utilisées par le microcircuit. Dans ce même but, les attaques de type EMA (Electromagnetic Analysis) se basent sur l'analyse du rayonnement électromagnétique émis par le microcircuit. Les commutations de portes logiques notamment entrainent des variations de consommation de courant électrique et de rayonnement électromagnétique du circuit. En détectant ces variations, il peut donc être possible de déterminer les données en entrée ou en sortie de portes logiques.

On connaît également les attaques par injection de faute qui consistent à introduire des perturbations dans le microcircuit pendant qu'il exécute des algorithmes sensibles tels que des algorithmes cryptographiques, ou dans le but de déclencher l'exécution d'une routine de téléchargement émettant sur un port les données qu'il mémorise. Une telle perturbation peut être réalisée en appliquant au microcircuit un ou plusieurs éclairages brefs ou un ou plusieurs pics de tension sur l'un de ses contacts.

Ces attaques variées par nature peuvent être combinées, notamment pour exploiter des déséquilibres statistiques. De tels déséquilibres apparaissent notamment dans certaines portes logiques simples comme les portes de type ET, NON ET, OU et NON OU (AND, NAND, OR, NOR). En effet, si l'on considère le cas d'une porte logique de type ET à laquelle sont fournies en entrée des données binaires aléatoires ayant une probabilité égale à 1/2 d'être à l'état 0 ou 1. Statistiquement et compte tenu de la table de vérité de la fonction logique ET, la sortie de la porte sera à l'état 0 avec une probabilité de 3/4 et à l'état 1 avec une probabilité de 1/4. Dans le cas d'une porte logique de type OU, la sortie de la porte sera à l'état 1 avec une probabilité de 3/4, et à l'état 0 avec une probabilité de 1/4. En revanche, les portes logiques de type OU EXCLUSIF inversé ou non, de type inverseur, et les portes de transfert (ou tampon) sont équilibrées statistiquement puisque leur sortie est à l'état 0 ou 1 avec une probabilité de 1/2 si elles reçoivent en entrée des données binaires aléatoires (à l'état 0 ou 1 avec une probabilité de 1/2).

Pour protéger un circuit logique contre des attaques telles que SPA, DPA ou EMA, il est connu de prévoir une phase de précharge du circuit logique avant chaque phase de traitement de données. Durant chaque phase de précharge, des données binaires aléatoires sont fournies en entrée du circuit logique afin de déclencher aléatoirement des commutations de portes dans le circuit logique. Toutefois, si durant une phase de traitement, une porte logique de type ET reçoit des données d'entrée toutes deux à 1, la sortie de la porte s'établit à 1 en commutant de 0 à 1 avec une probabilité de 3/4, puisque la sortie de la porte était à 0 avec cette probabilité après la phase de précharge. Si les données à traiter fournies à la porte ET sont respectivement à 0 et 1 ou toutes deux à 0, la sortie de la porte s'établit à 0 en commutant de 1 à 0 avec une probabilité de 1/4, puisque la sortie de la porte est à 1 avec cette probabilité après la précharge. Des observations analogues peuvent être effectuées sur des portes logiques de type NON ET, OU et NON OU.

Il en résulte que même en effectuant une précharge, un circuit logique peut présenter un nombre statistique moyen de commutations de portes logiques dépendant uniquement des valeurs des données à traiter fournies en entrée du circuit durant la phase de traitement. Les commutations des portes logiques d'un circuit logique génèrent donc une fuite d'information qui peut être exploitée par des attaques SPA, DPA ou EMA qui peuvent être combinées.

Il est donc souhaitable de protéger les données qui circulent dans un circuit logique contre de telles attaques.

Un mode de réalisation concerne un procédé de contremesure dans un circuit logique comprenant une porte logique fournissant un signal de sortie binaire, le procédé comprenant des étapes de fourniture de données binaires ayant des valeurs aléatoires à des entrées du circuit logique durant une phase de précharge, et de fourniture de données à traiter aux entrées du circuit logique durant une phase de traitement de données. Selon un mode de réalisation, le procédé comprend des étapes consistant à : fournir en entrée du circuit logique un signal de commande de précharge déclenchant une phase de précharge, et sous l'effet du signal de commande de précharge, adapter le fonctionnement d'une porte logique du circuit logique, non équilibrée statistiquement, pour que le signal sortie de la porte logique soit dans un état binaire avec une même probabilité que les données binaires aléatoires fournies en entrée du circuit logique durant la phase de précharge.

Selon un mode de réalisation, toutes les entrées sauf une de la porte logique sont forcées à une certaine valeur de forçage, sous l'effet du signal de commande de précharge, pour transformer la porte logique en une porte de transfert ou inverseuse.

Selon un mode de réalisation, le procédé comprend une étape de prévision d'un multiplexeur pour chaque entrée de la porte logique sauf une, connecté en sortie à l'entrée de la porte logique et recevant sur une entrée une donnée d'entrée de la porte logique et sur une autre entrée la valeur de forçage, et sur une entrée de commande le signal de commande de précharge.

Selon un mode de réalisation, sous l'effet du signal de commande de précharge, toutes les entrées sauf une de la porte logique sont désactivées et la porte logique est transformée en une porte de transfert ou inverseuse pour l'entrée non désactivée.

Selon un mode de réalisation, le procédé comprend une étape mise en court circuit de transistors de la porte logique interconnectés en série et commandés par les entrées de la porte logique sauf une et de mise hors circuit de transistors interconnectés en parallèle et commandés par les entrées de la porte logique sauf une, sous l'effet du signal de commande de précharge.

Selon un mode de réalisation, la porte logique est une porte de type ET, NON ET, OU ou NON OU.

Selon un mode de réalisation, chacune des portes logiques du circuit logique, présentant un fonctionnement non équilibré statistiquement, est modifiée pour que le signal sortie de la porte logique soit dans un état binaire avec une même probabilité que les données binaires aléatoires fournies en entrée du circuit logique, sous l'effet du signal de commande de précharge.

Un mode de réalisation concerne également un dispositif de contremesure dans un circuit logique comprenant une porte logique fournissant un signal de sortie binaire. Selon un mode de réalisation, le dispositif est configuré pour mettre en oeuvre le procédé défini précédemment.

Selon un mode de réalisation, la porte logique comprend un multiplexeur pour chaque entrée de la porte logique sauf une, connecté en sortie à l'entrée de la porte logique et recevant sur une entrée une donnée d'entrée de la porte logique, sur une entrée de commande le signal de commande de précharge, et sur une autre entrée une valeur de forçage transformant la porte logique en une porte de transfert ou inverseuse.

Selon un mode de réalisation, la porte logique est configurée pour désactiver toutes les entrées sauf une de la porte logique et se transformer en une porte de transfert ou inverseuse pour l'entrée non désactivée, sous l'effet du signal de commande de précharge.

Selon un mode de réalisation, la porte logique comprend des transistors interconnectés en série à la sortie de la porte logique et commandés chacun par une entrée de la porte logique, des transistors interconnectés en parallèle à la sortie de la porte logique et commandés chacun par une entrée de la porte logique, un transistor commandé par le signal de commande de précharge mettant en court circuit tous les transistors interconnectés en série sauf un lorsque le signal de commande de précharge est actif, et un transistor commandé par le signal de commande de précharge mettant hors circuit tous les transistors interconnectés en parallèle sauf un lorsque le signal de commande de précharge est actif.

Selon un mode de réalisation, la porte logique est une porte de type ET, NON ET, OU ou NON OU.

Selon un mode de réalisation, chacune des portes logiques du circuit logique, présentant un fonctionnement non équilibré statistiquement, est modifiée pour que le signal sortie de la porte logique soit dans un état binaire avec une même probabilité que les données binaires aléatoires fournies en entrée du circuit logique sous l'effet du signal de commande de précharge.

Un mode de réalisation concerne également un composant électronique, comprenant un dispositif de contremesure tel que défini précédemment.

Un mode de réalisation concerne également un dispositif portable à microcircuit, caractérisé en ce qu'il comprend un composant électronique tel que défini précédemment.

Des exemples de réalisation de l'invention seront décrits dans ce qui suit, à titre non limitatif en relation avec les figures jointes parmi lesquelles :
la figure 1 représente un exemple de circuit logique,
la figure 2 représente le circuit logique de la figure 1, protégé selon un mode de réalisation,
les figures 3A, 3B représentent le circuit logique de la figure 1, protégé selon un autre mode de réalisation, dans une phase de précharge et dans une phase de traitement,
les figures 4A, 4B représentent le circuit logique de la figure 1, protégé selon un autre mode de réalisation, dans une phase de précharge et dans une phase de traitement,
les figures 5 et 6 représentent des portes logiques protégées selon un mode de réalisation,
la figure 7 représente un circuit logique comprenant des portes logiques protégées,
la figure 8 représentent une porte logique protégée selon un autre mode de réalisation.

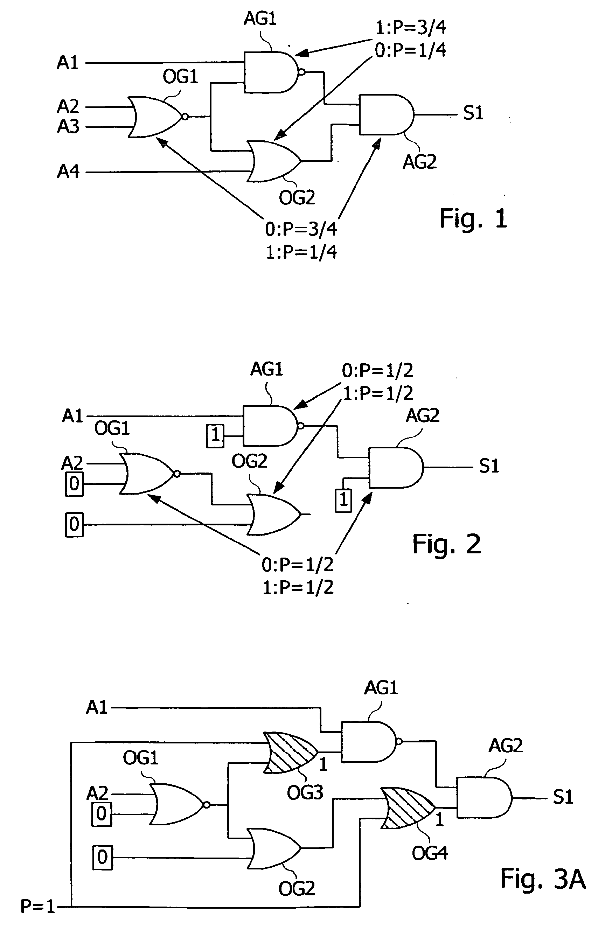

La figure 1 représente un exemple de circuit logique comprenant quatre portes logiques AG1, AG2, OG1, OG2, quatre entrées A1, A2, A3, A4 et une sortie S. La porte OG1 est de type NON OU et est connectée en entrée aux entrées A2 et A3. La porte AG2 est de type NON ET et est connectée en entrée à l'entrée A1 et à la sortie de la porte OG1. La porte OG2 est de type OU et est connectée en entrée à l'entrée A4 et à la sortie de la porte OG1. La porte AG2 est de type ET et est connectée en entrée aux sorties des portes AG1 et OG2, et en sortie à la sortie S1 du circuit logique. Si l'on applique aux entrées A1-A4 des données aléatoires (ayant une probabilité égale à 1/2 d'être à 0 ou 1), la sortie des portes OG1 et AG2 s'établit à 0 avec une probabilité de 3/4 et à 1 avec une probabilité de 1/4. La sortie des portes OG2 et AG1 s'établit à 1 avec une probabilité de 3/4 et à 0 avec une probabilité de 1/4. Il en résulte que les sorties des portes AG1 et OG2 seront à 1 avec une probabilité de 7/8 et à 0 avec une probabilité de 1/8. La sortie S1 du circuit sera donc à 0 avec une probabilité de 15/64 et à 1 avec une probabilité de 49/64.

La figure 2 représente le circuit logique de la figure 1, protégé contre des attaques de type SPA, DPA, EMA, en forçant, pendant une phase de précharge précédant une phase de traitement, toutes les entrées sauf une de chaque porte logique statistiquement déséquilibrée, à une valeur telle que la porte assure pour l'entrée non forcée une fonction de tampon ou d'inverseur. De cette manière, la probabilité que la sortie de chaque porte soit à 0 ou 1 passe à 1/2 lorsqu'une valeur aléatoire présentant cette probabilité d'être à 0 ou 1, est fournie à l'entrée non forcée de la porte. Ainsi, dans l'exemple de la figure 2, une entrée des portes logiques de type NON ET et ET AG1, AG2 est forcée à un, et une entrée des portes logiques de type OU et NON OU OG1, OG2 est forcée à 0. Au lieu de fournir quatre valeurs aléatoires aux entrées A1 à A4 durant la phase de précharge, les entrées A3 et A4 sont mises à 0, et des données binaires de valeur aléatoire (à 0 ou 1 avec une probabilité de 1/2) sont fournies aux entrées A1 et A2 du circuit logique. La sortie de chacune des portes OG1, OG2, AG1, AG2 s'établit alors à 0 ou 1 avec une probabilité de 1/2.

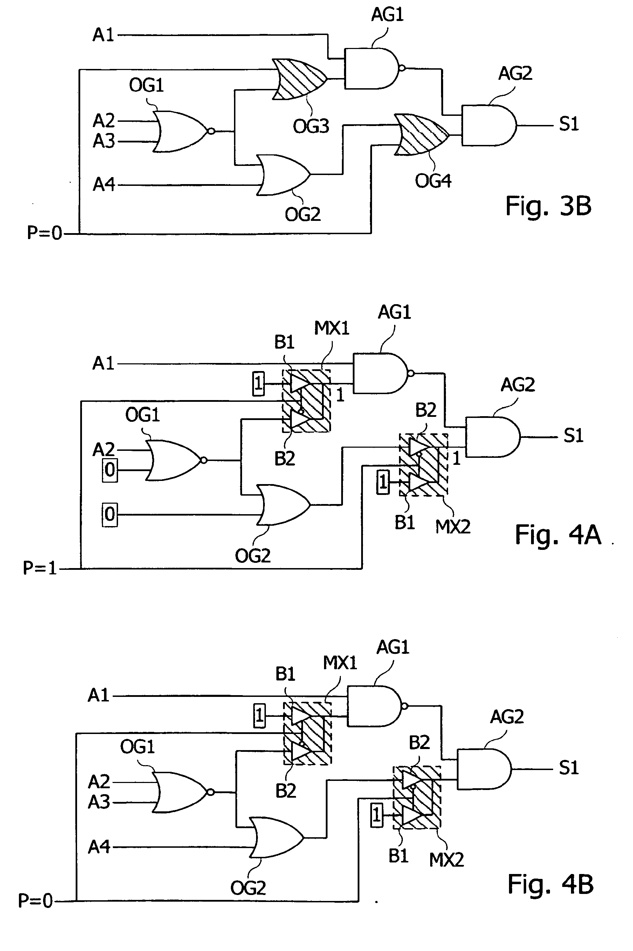

Pour forcer des entrées de portes qui ne sont pas accessibles en entrée du circuit logique, il suffit de prévoir des multiplexeurs ou des portes supplémentaires comme illustré sur les figures 3A et 3B. Les figures 3A, 3B représentent ainsi un mode de réalisation du circuit logique qui diffère de celui de la figure 1 en ce qu'il comprend une porte OG3 de type OU connectée entre les portes OG1 et AG1, et une porte OG4 de type OU connectée entre les portes OG2 et AG2. Durant la phase de précharge illustrée par la figure 3A, une entrée de chacune des portes OG3 et OG4 non reliée au circuit logique est forcée à 1. De cette manière, la sortie des portes OG3 et OG4 se trouve à un durant la phase de précharge, ce qui permet de forcer à 1 une entrée des portes AG1 et AG2. Durant une phase de traitement, illustrée par la figure 3B, l'entrée forcée à 1 des portes OG3 et OG4 est placée à 0, de manière à rendre ces portes transparentes. Les portes supplémentaires OG3, OG4 vont donc changer d'état durant la phase de traitement si respectivement la sortie de la porte OG1 et la sortie de la porte OG2 est à 0. Il en résulte que les portes OG3 et OG4 ne vont pas changer d'état si les données à traiter fournies aux entrées A2 et A3 sont toutes deux à 0. La porte OG3 va changer d'état si les entrée A2 et A3 ne sont pas toutes les deux à 0. La porte OG4 va changer d'état si la porte OG3 change d'état et si l'entrée A3 est à 0. Par conséquent, les portes logiques ajoutées peuvent fournir une information sur les données à traiter fournies en entrée du circuit logique.

Les figures 4A, 4B représentent un autre mode de réalisation du circuit logique. Le circuit logique représenté sur la figure diffère de celui de la figure 3 en ce que les portes supplémentaires OG3 et OG4 sont remplacées par des multiplexeurs à deux entrées MX1, MX2 recevant sur une entrée de commande le signal de commande de précharge P. Chacun multiplexeurs MX1, MX2 comprend deux portes de transfert B1, B2 à trois états (tri-state buffer) comportant chacune une entrée de donnée, une entrée de commande d'activation et une sortie. L'entrée d'activation de la porte B2 de chacun des multiplexeurs MX1, MX2 est inversée, tandis que celle de la porte B1 n'est pas inversée. L'entrée de commande de chacun des multiplexeurs MX1, MX2 est connectée aux entrées d'activation des deux portes B1, B2. L'entrée de la porte B2 du multiplexeur MX1 est connectée à la sortie de la porte OG1, et l'entrée de la porte B1 du multiplexeur MX1 est forcée à 1. Les sorties des portes B1, B2 du multiplexeur MX1 sont connectées à une entrée de la porte AG1. L'entrée de la porte B2 du multiplexeur MX2 est connectée à la sortie de la porte OG2, et l'entrée de la porte B1 du multiplexeur MX2 est forcée à 1. Les sorties des portes B1, B2 du multiplexeur MX2 sont connectées à une entrée de la porte AG2. De cette manière, une seule porte B1, B2 de chacun des deux multiplexeurs MX1, MX2 est active pendant que l'autre présente une sortie en haute impédance. En phase de précharge illustrée par la figure 4A, l'entrée de commande de chacun des deux multiplexeurs MX1, MX2 est placée à 1. De cette manière, les portes B1 des multiplexeurs MX1, MX2 sont actives et les portes B2 inactives. Les multiplexeurs forcent ainsi une entrée de chacune des portes AG1, AG2 à 1. En phase de traitement illustrée par la figure 4B, l'entrée de commande P de chacun des deux multiplexeurs MX1, MX2 est placée à 0. Les multiplexeurs MX1, MX2 relient alors la sortie de la porte OG1 à l'entrée de la porte AG1, et la sortie de la porte OG2 à l'entrée de la porte AG2. Ainsi, lorsque les données à traiter se propagent dans le circuit logique à la fin de la phase de précharge, les portes B1, B2 dans les multiplexeurs MX1, MX2 changent d'état systématiquement, c'est-à-dire indépendamment des valeurs des données à traiter.

Bien entendu, un multiplexeur à deux entrées peut être utilisé pour forcer une entrée d'une porte ET ou NON ET à 0, en mettant l'entrée de la porte B1 à 0. Il est à noter que les rôles des portes B1, B2 dans les multiplexeurs MX1, MX2, peuvent être échangés, les portes B2 étant utilisées pour forcer une entrée de la porte logique en phase de précharge, et les portes B1 pour transmettre à cette entrée une donnée élaborée dans une porte logique précédente durant une phase de traitement. Dans ce cas l'entrée de commande des multiplexeurs est placée à l'état 0 pendant la phase de précharge et à 1 pendant la phase de traitement.

Dans le circuit logique des figures 2 à 4B, il peut être envisagé de forcer à 1 l'entrée A1 et de conserver la liaison entre la sortie de la porte OG1 et l'entrée de la porte AG1, pendant la phase de précharge. Une seule donnée aléatoire est alors fournie à l'entrée A2 du circuit pendant la phase de précharge. Il en résulte que dans l'exemple de la figure 3, la porte supplémentaire OG3 n'est pas nécessaire. Dans l'exemple de la figure 4, le multiplexeur MX1 n'est pas non plus nécessaire.

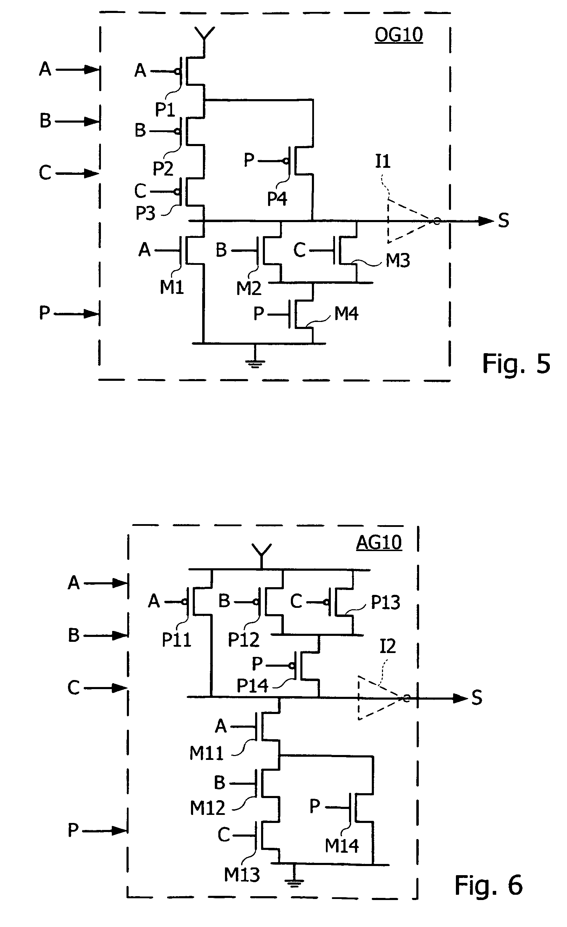

Dans la description qui précède, un équilibrage statistique de portes logiques d'un circuit logique a été réalisé en ajoutant des portes supplémentaires au circuit logique en entrée des portes logiques à équilibrer. Un tel équilibrage statistique peut être également réalisé en modifiant chaque porte logique à équilibrer. Ainsi, la figure 5 représente une porte logique de type NON OU à trois entrées A, B, C, modifiée pour obtenir un tel équilibrage statistique. Sur la figure 5, la porte logique OG10 comprend trois transistors de type PMOS P1, P2, P3 connectés en série entre la source d'alimentation et la sortie S de la porte, et trois transistors de type NMOS M1, M2, M3 connectés à la sortie S de la porte. L'entrée A est connectée à la grille des transistors P1 et M1, l'entrée B à la grille des transistors P2 et M2, et l'entrée C à la grille des transistors P3 et M3. Le drain du transistor P1 reçoit la tension d'alimentation de la porte OG10. La source du transistor P1 est connectée au drain du transistor P2, et la source du transistor P2 est connectée au drain du transistor P3. La source du transistor P3 est connectée à la sortie S de la porte OG10. La source des transistors M1, M2, M3 est connectée à la sortie S. Le drain du transistor M1 est connecté à la masse.

Selon un mode de réalisation, la porte OG10 comprend une entrée supplémentaire prévue pour recevoir un signal de commande de précharge P de la porte logique, et deux transistors supplémentaires P4, M4 de types PMOS et NMOS, recevant le signal P sur leur grille. Le transistor P4 permet en phase de précharge de mettre en court circuit tous les transistors connectés en série P2, P3 de la porte sauf un (P1), et le transistor M4 permet de mettre hors circuit tous les transistors M2, M3 connectés en parallèle de la porte sauf un (M1). A cet effet, le drain du transistor P4 est connecté à la source du transistor P1, et la source du transistor P4 est connectée à la sortie S. La source du transistor M4 est connectée aux drains des transistors M2 et M3, et le drain du transistor M4 est connecté à la masse.

Lorsque l'entrée P reçoit un signal de précharge à 0, le transistor P4 est passant, reliant la source du transistor P1 directement à la sortie S de la porte OG10 et court-circuitant les transistors P2 et P3. Le transistor M4 est bloqué. Les transistors M2 et M3 sont ainsi mis hors circuit. La porte OG10 se comporte alors comme un inverseur ayant A pour entrée et S pour sortie. Les entrées B et C sont ainsi rendues inactives. Si l'entrée A reçoit une donnée aléatoire (ayant une probabilité de 1/2 d'être à 0 ou 1), la sortie S de la porte sera à 0 ou 1 également avec une probabilité de 1/2. Il en résulte que la porte OG10 en phase de précharge est statistiquement équilibrée. En phase de traitement, le signal P est mis à 1. Le transistor P4 est alors bloqué et le transistor M4 est passant. La porte OG10 assure alors la fonction d'une porte de type NON OU à trois entrées A, B, C.

Il est à noter qu'une porte à deux entrées, par exemple A, B peut être aisément réalisée en remplaçant le transistor P3 par une simple liaison électrique et en supprimant le transistor M3. Inversement, une porte à plus de trois entrées peut être réalisée en ajoutant des transistors de type PMOS en série avec les transistors P2, P3 entre la source du transistor P3 et la sortie S, et en ajoutant des transistors de type NMOS en parallèle avec les transistors M2, M3.

La figure 6 représente une porte logique de type NON ET à trois entrées A, B, C, modifiée pour pouvoir être équilibrée statistiquement dans une phase de précharge. Sur la figure 6, la porte logique AG10 comprend trois transistors de type PMOS P11, P12, P13 connectés à la source d'alimentation, et trois transistors de type NMOS M11, M12, M13 connectés en série entre la sortie S de la porte et la masse. L'entrée A est connectée à la grille des transistors P11 et M11, l'entrée B à la grille des transistors P12 et M12, et l'entrée C à la grille des transistors P13 et M13. Le drain de chacun des transistors P11, P12, P13 reçoit la tension d'alimentation de la porte AG10. La source du transistor P11 est connectée à la sortie S de la porte AG10. La source du transistor M11 est connectée à la sortie S. Le drain du transistor M11 est connecté à la source du transistor M12. Le drain du transistor M12 est connecté à la source du transistor M13. Le drain du transistor M13 est connecté à la masse.

Selon un mode de réalisation, la porte AG10 comprend une entrée supplémentaire prévue pour recevoir un signal de commande de précharge P de la porte logique, et deux transistors supplémentaires P14, M14 de types PMOS et NMOS, recevant le signal P sur leur grille. Le transistor P14 permet en phase de précharge de mettre en hors circuit tous les transistors connectés en parallèle P12, P13 de la porte sauf un (P11), et le transistor M4 permet de mettre en court circuit tous les transistors M12, M13 connectés en série de la porte sauf un (M11). A cet effet, le drain du transistor P14 est connecté à la source de chacun des transistors P12 et P13, et la source du transistor P14 est connecté à la sortie S. La source du transistor M14 est connectée au drain du transistor M11 et à la source du transistor M12. Le drain du transistor M14 est connecté à la masse.

Lorsque l'entrée P reçoit un signal de précharge à 0, le transistor P14 est bloqué, et le transistor M14 est passant. Seule la source du transistor P11 se trouve ainsi reliée à la sortie S de la porte AG10. Les transistors P12 et P13 se trouvent alors hors circuit. Le drain du transistor M11 se trouve relié à la masse et les transistors M12 et M13 sont court-circuités. La porte AG10 se comporte alors également comme un inverseur ayant A pour entrée et S pour sortie. Les entrées B et C sont ainsi rendues inactives. Si l'entrée A reçoit une donnée aléatoire (ayant une probabilité de 1/2 d'être à 0 ou 1 ), la sortie S de la porte sera à 0 ou 1 également avec une probabilité de 1/2. Il en résulte que la porte AG10 en phase de précharge est statistiquement équilibrée. En phase de traitement, le signal P est à 0. Le transistor P14 est alors passant et le transistor M14 est bloqué. La porte AG10 assure alors la fonction d'une porte de type NON ET à trois entrées A, B, C.

Il est à noter qu'une porte à deux entrées, par exemple A, B, peut être aisément réalisée supprimant le transistor P13, et en remplaçant le transistor M13 par une simple liaison électrique. Inversement, une porte à plus que trois entrées peut être réalisée en ajoutant des transistors PMOS en parallèle avec les transistors P12, P13, et en ajoutant des transistors NMOS en série avec les transistors M12, M13, entre le transistor M13 et la masse.

Une porte logique de type OU peut aisément être réalisée à partir de la porte OG10 (figure 5) en ajoutant un inverseur 11 à la sortie S de la porte. De même, une porte logique de type ET peut être réalisée à partir de la porte AG10 (figure 6) en ajoutant un inverseur 12 à la sortie S de la porte. La présence d'un tel inverseur ne modifie en rien l'équilibre statistique des portes OG10, AG10 en phase de précharge.

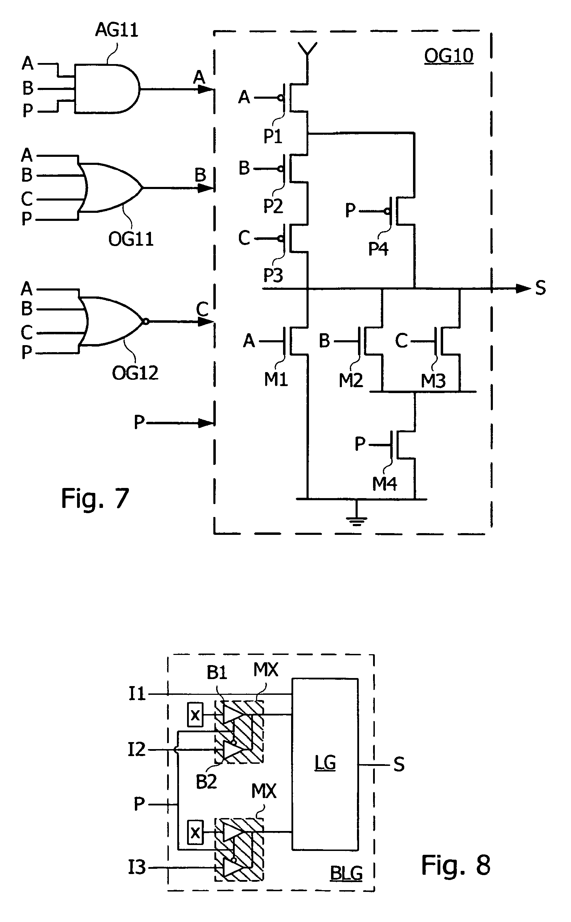

La figure 7 représente un circuit logique comprenant la porte logique OG10 et des portes logiques OG11, OG12, AG11, modifiées par exemple comme représenté sur les figures 5 et 6, afin de comporter chacune une entrée de commande de précharge P permettant de transformer la porte en phase de précharge en une porte équilibrée statistiquement. Les sorties des portes AG11, OG11, OG12 sont connectées respectivement aux entrées A, B, C de la porte OG10. En phase de précharge, l'entrée P de chaque porte est activée et des données aléatoires (à 0 ou 1 avec une probabilité de 1/2) sont fournies aux entrées A des portes AG11, OG11 et OG12. La porte AG11 fournit alors une donnée aléatoire à 0 ou 1 avec une probabilité de 1/2 sur l'entrée A de la porte OG10. Cette donnée aléatoire va se propager dans la porte OG10 jusqu'à la sortie S de cette porte. La sortie S de la porte OG10 se trouve donc à 0 ou 1 avec une probabilité de 1/2. Les portes OG11 et OG12 fournissent également des données aléatoires sur les entrées B et C de la porte OG10. Or en phase de précharge, les entrées B et C de la porte OG10 sont inactives, les données aléatoires aux entrées B et C ne modifient donc pas la sortie S de la porte OG10. Toutefois, d'un point de vue électrique, ces données aléatoires peuvent changer l'état des transistors P2, P3, M2, M3, et ainsi masquer des commutations. A la fin de la phase de précharge, les entrées P de chaque porte sont désactivées.

En résumé, le forçage à 0 ou 1 de toutes entrées sauf une d'une porte logique (figures 2 à 4), pendant une phase de précharge, ou l'adaptation de la porte logique réalisée sur les figures 5 et 6 permet de transformer pendant la phase de précharge, une porte logique non équilibrée en une porte de transfert ou un inverseur qui sont statistiquement équilibrés.

Un circuit logique présentant un mode de précharge dans lequel tout ou partie des portes logiques sont équilibrées statistiquement peut aisément être réalisé en utilisant une bibliothèque de portes logiques dans laquelle les portes logiques non équilibrées statistiquement sont remplacées par des portes logiques telles que représentées sur les figures 5 et 6, ou sur la figure 8. La figure 8 représente une porte logique BLG ayant un mode de précharge dans lequel la porte est équilibrée statistiquement, réalisée à partir d'une porte logique non équilibrée statistiquement LG. La porte BLG comprend une sortie S connectée à la sortie de la porte LG, et une première entrée 11 connectée à une première entrée de la porte LG. Toutes les entrées 12, 13 de la porte BLG, sauf la première entrée 11, sont reliées à une entrée correspondante de la porte LG, par l'intermédiaire d'un multiplexeur MX respectif qui peut être identique à ceux des figures 4A, 4B. Chaque multiplexeur MX est commandé par le signal de commande de précharge P. Une entrée de chaque multiplexeur MX est forcée à une valeur x égale à 0 ou 1 selon le type de la porte LG. De cette manière, toutes les entrées sauf une (l'entrée 11) sont forcées à la valeur x lorsque le signal de précharge P est actif.

Il apparaîtra clairement à l'homme de l'art que la présente invention est susceptible de diverses variantes de réalisation. En particulier, l'invention n'est pas limitée à la transformation, durant une phase de précharge, d'une porte logique non équilibrées statistiquement en une porte de transfert ou un inverseur. En effet, le signal de précharge peut permettre de transformer la porte en une porte équilibrée d'un autre type, comme OU Exclusif, direct ou inversé.

Il n'est pas non plus nécessaire de modifier toutes les portes logiques non équilibrées statistiquement d'un circuit logique. Il suffit en effet que certaines portes du circuit logique, par exemple les portes recevant directement les données d'entrée du circuit logique, soient modifiées pour perturber une analyse statistique des résultats observés notamment à la suite d'attaques de type SDA.

## Revendications

1. Procédé de contremesure dans un circuit logique comprenant une porte logique (OG1, OG2, AG1, AG2, OG10-OG12, AG10, AG11, LG) fournissant un signal de sortie binaire (S), le procédé comprenant des étapes de fourniture de données binaires ayant des valeurs aléatoires à des entrées (A1-A4) du circuit logique durant une phase de précharge, et de fourniture de données à traiter aux entrées du circuit logique durant une phase de traitement de données,
**caractérisé en ce qu'**il comprend des étapes consistant à :
fournir en entrée du circuit logique un signal de commande de précharge (P) déclenchant une phase de précharge, et
sous l'effet du signal de commande de précharge, adapter le fonctionnement d'une porte logique (OG10, AG10, LG) du circuit logique, non équilibrée statistiquement, pour que le signal sortie (S) de la porte logique soit dans un état binaire avec une même probabilité que les données binaires aléatoires fournies en entrée du circuit logique durant la phase de précharge.

2. Procédé selon la revendication 1, dans lequel toutes les entrées (B, C, 12, 13) sauf une (A, 11) de la porte logique (OG1 0, AG10, LG) sont forcées à une certaine valeur de forçage (x), sous l'effet du signal de commande de précharge, pour transformer la porte logique en une porte de transfert ou inverseuse.

3. Procédé selon la revendication 2, comprenant une étape de prévision d'un multiplexeur (MX, MX1, MX2) pour chaque entrée (12,13) de la porte logique (AG1, AG2, LG) sauf une (11), connecté en sortie à l'entrée de la porte logique et recevant sur une entrée une donnée d'entrée de la porte logique et sur une autre entrée la valeur de forçage (x), et sur une entrée de commande le signal de commande de précharge (P).

4. Procédé selon la revendication 1, dans lequel, sous l'effet du signal de commande de précharge (P), toutes les entrées (B, C) sauf une de la porte logique (OG10, AG10) sont désactivées et la porte logique est transformée en une porte de transfert ou inverseuse pour l'entrée non désactivée (A).

5. Procédé selon la revendication 4, comprenant une étape mise en court circuit de transistors (P2, P3, M12, M13) de la porte logique (OG10, AG10) interconnectés en série et commandés par les entrées (B, C) de la porte logique sauf une (A) et de mise hors circuit de transistors (M2, M3, P12, P13) interconnectés en parallèle et commandés par les entrées (B, C) de la porte logique sauf une (A), sous l'effet du signal de commande de précharge (P).

6. Procédé selon l'une des revendications 1 à 5, dans lequel la porte logique (OG1, OG2, AG1, AG2, OG10-OG12, AG10, AG11) est une porte de type ET, NON ET, OU ou NON OU.

7. Procédé selon l'une des revendications 1 à 6, dans lequel chacune des portes logiques (OG1, OG2, AG1, AG2, OG10-OG12, AG10, AG11, LG) du circuit logique, présentant un fonctionnement non équilibré statistiquement, est modifiée pour que le signal sortie de la porte logique soit dans un état binaire avec une même probabilité que les données binaires aléatoires fournies en entrée du circuit logique, sous l'effet du signal de commande de précharge (P).

8. Dispositif de contremesure dans un circuit logique comprenant une porte logique (OG1, OG2, AG1, AG2, OG10-OG12, AG10, AG11, LG) fournissant un signal de sortie binaire (S),
**caractérisé en ce qu'**il est configuré pour mettre en oeuvre le procédé selon l'une des revendications 1 à 7.

9. Dispositif selon la revendication 8, dans lequel la porte logique (AG1, AG2, LG) comprend un multiplexeur (MX, MX1, MX2) pour chaque entrée (I2, I3) de la porte logique sauf une (11), connecté en sortie à l'entrée de la porte logique et recevant sur une entrée une donnée d'entrée de la porte logique, sur une entrée de commande le signal de commande de précharge (P), et sur une autre entrée une valeur de forçage (x) transformant la porte logique en une porte de transfert ou inverseuse.

10. Dispositif selon la revendication 8, dans lequel la porte logique (OG10, AG10) est configurée pour désactiver toutes les entrées (B, C) sauf une (A) de la porte logique et se transformer en une porte de transfert ou inverseuse pour l'entrée non désactivée, sous l'effet du signal de commande de précharge (P).

11. Dispositif selon la revendication 10, dans lequel la porte logique comprend des transistors (P1-P3, M11-M13) interconnectés en série à la sortie (S) de la porte logique et commandés chacun par une entrée (A, B, C) de la porte logique, des transistors (M1-M3, P11-P13) interconnectés en parallèle à la sortie de la porte logique et commandés chacun par une entrée de la porte logique, un transistor (P4, M14) commandé par le signal de commande de précharge (P) mettant en court circuit tous les transistors interconnectés en série sauf un (P1, M11) lorsque le signal de commande de précharge est actif, et un transistor (M4, P14) commandé par le signal de commande de précharge mettant hors circuit tous les transistors interconnectés en parallèle sauf un (M1, P11) lorsque le signal de commande de précharge est actif.

12. Dispositif selon l'une des revendications 8 à 11, dans lequel la porte logique (OG1, OG2, AG1, AG2, OG10-OG12, AG10, AG11) est une porte de type ET, NON ET, OU ou NON OU.

13. Dispositif selon l'une des revendications 8 à 12, dans lequel chacune des portes logiques (OG1, OG2, AG1, AG2, OG10-OG12, AG10, AG11, LG) du circuit logique, présentant un fonctionnement non équilibré statistiquement, est modifiée pour que le signal sortie de la porte logique soit dans un état binaire avec une même probabilité que les données binaires aléatoires fournies en entrée du circuit logique sous l'effet du signal de commande de précharge (P).

14. Composant électronique, **caractérisé en ce qu'**il comprend un dispositif de contremesure selon l'une des revendications 8 à 13.

15. Dispositif portable à microcircuit, **caractérisé en ce qu'**il comprend un composant électronique selon la revendication 14.

## Claims

1. A countermeasure method in a logic circuit comprising a logic gate (OG1, OG2, AG1, AG2, OG10-OG12, AG10, AG11, LG) supplying a binary output signal (S), the method comprising steps of supplying binary data having random values to inputs (A1-A4) of the logic circuit during a precharge phase, and of supplying data to process to inputs of the logic circuit during a data processing phase,
**characterized in that** it comprises steps consisting of:
supplying on input of the logic circuit a precharge command signal (P) launching a precharge phase, and
under the effect of the precharge command signal, adapting the functioning of a logic gate (OG10, AG10, LG) of the logic circuit, statistically unbalanced, so that the output signal (S) of the logic gate is in a binary state with a same probability as the random binary data supplied on input of the logic circuit during the precharge phase.

2. A method according to claim 1, wherein all the inputs (B, C, 12, 13) except one (A, I1) of the logic gate (OG10, AG10, LG) are forced to a certain forced value (x), under the effect of the precharge command signal, to change the logic gate into a buffer or inverting gate.

3. A method according to claim 2, comprising a step of providing a multiplexer (MX, MX1, MX2) for each input (I2, I3) of the logic gate (AG1, AG2, LG) except one (11), connected on output to the input of the logic gate and receiving on one input an input data of the logic gate and on another input the forced value (x), and on a command input the precharge command signal (P).

4. A method according to claim 1, wherein, under the effect of the precharge command signal (P), all the inputs (B, C) except one of the logic gate (OG10, AG1 0) are deactivated and the logic gate is changed into a buffer or inverter gate for the non-deactivated input (A).

5. A method according to claim 4, comprising a step of short-circuiting transistors (P2, P3, M12, M13) except one (A) of the logic gate (OG10, AG10) interconnected in series and controlled by the inputs (B, C) of the logic gate, and of disconnecting transistors (M2, M3, P12, P13) except one (A) of the logic gate interconnected in parallel and commanded by the inputs (B, C), under the effect of the precharge command signal (P).

6. A method according to one of claims 1 to 5, wherein the logic gate (OG1, OG2, AG1, AG2, OG10-OG12, AG10, AG11) is a gate of the AND, NAND, OR, or NOR type.

7. A method according to one of claims 1 to 6, wherein each of the logic gates (OG1, OG2, AG1, AG2, OG10-OG12, AG10, AG11, LG) of the logic circuit, presenting a statistically-unbalanced functioning, is modified so that the output signal of the logic gate is in a binary state with a same probability as the random binary data supplied on input of the logic circuit, under the effect of the precharge command signal (P).

8. A countermeasure device in a logic circuit comprising a logic gate (OG1, OG2, AG1, AG2, OG10-OG12, AG10, AG11, LG) supplying a binary output signal (S),
**characterized in that** it is configured to implement the method according to one of claims 1 to 7.

9. A device according to claim 8, wherein the logic gate (AG1, AG2, LG) comprises a multiplexer (MX, MX1, MX2) for each input (I2, I3) of the logic gate except one (11), connected on output to the input of the logic gate and receiving on one input an input data of the logic gate, on a control input the precharge command signal (P), and on another input a forced value (x) changing the logic gate into a buffer or inverting gate.

10. A device according to claim 8, wherein the logic gate (OG10, AG10) is configured to deactivate all the inputs (B, C) except one (A) of the logic gate and to change into a buffer or inverting gate for the non-deactivated input, under the effect of the precharge command signal (P).

11. A device according to claim 10, wherein the logic gate comprises transistors (P1-P3, M11-M13) interconnected in series to the output (S) of the logic gate and each controlled by an input (A, B, C) of the logic gate, transistors (M1-M3, P11-P13) interconnected in parallel to the output of the logic gate and each controlled by an input of the logic gate, a transistor (P4, M14) controlled by the precharge command signal (P) short-circuiting all the transistors interconnected in series except one (P1, M11) when the precharge command signal is active, and a transistor (M4, P14) controlled by the precharge command signal disconnecting all the transistors interconnected in parallel except one (M1, P11) when the precharge command signal is active.

12. A device according to one of claims 8 to 11, wherein the logic gate (OG1, OG2, AG1, AG2, OG10-OG12, AG1 0, AG11) is a gate of the AND, NAND, OR, or NOR type.

13. A device according to one of claims 8 to 12, wherein each of the logic gates (OG1, OG2, AG1, AG2, OG10-OG12, AG10, AG11, LG) of the logic circuit, presenting a statistically unbalanced functioning, is modified so that the output signal of the logic gate is in a binary state with a same probability as the random binary data supplied on input of the logic circuit under the effect of the precharge command signal (P).

14. An electronic component, **characterized in that** it comprises a countermeasure device according to one of claims 8 to 13.

15. A portable device with a microcircuit, **characterized in that** it comprises an electronic component according to claim 14.

## Patentansprüche

1. Verfahren zur Gegenmaßnahme in einer Logikschaltung, umfassend eine ein binäres Ausgangssignal (S) liefernde Torschaltung (OG1, OG2, AG1, AG2, OG10-OG12, AG10, AG11, LG), das Verfahren umfassend Schritte zur Lieferung von Binärdaten mit Zufallswerten an Eingängen (A1-A4) der Logikschaltung während einer Vorladephase, und zur Lieferung von zu bearbeitenden Daten an den Eingängen der Logikschaltung während einer Datenverarbeitungsphase,
**dadurch gekennzeichnet, dass** es Schritte umfasst, die darin bestehen,
ein eine Vorladephase auslösendes Vorlade-Steuersignal (P) am Eingang der Logikschaltung zu liefern, und
unter der Wirkung des Vorlade-Steuersignals den Betrieb einer nicht statistisch ausgeglichenen Torschaltung (OG10, AG10, LG) der Logikschaltung so anzupassen, dass das Ausgangssignal (S) der Torschaltung in einem binären Zustand mit einer gleichen Wahrscheinlichkeit steht, wie die zufälligen am Eingang der Logikschaltung während der Vorladephase gelieferten Binärdaten.

2. Verfahren nach Anspruch 1, bei dem unter der Wirkung des Vorlade-Steuersignals alle Eingänge (B, C, 12, I3) der Torschaltung (OG10, AG10, LG) ausgenommen von einem (A, I1) zu einem bestimmten Erzwingungswert (x) erzwungen werden, um die Torschaltung in ein Übertragungs- oder Invertiergatter zu transformieren.

3. Verfahren nach Anspruch 2, umfassend einen Schritt des Vorsehens eines Multiplexers (MX, MX1, MX2) für jeden Eingang (I2, I3) der Torschaltung (AG1, AG2, LG) ausgenommen von einem (11), dessen Ausgang mit dem Eingang der Torschaltung verbunden ist und welcher auf einem seiner Eingänge ein Eingangsdatum der Torschaltung empfängt, auf einem anderen Eingang den Erzwingungswert (x), und auf einem Steuereingang das Vorlade-Steuersignal (P).

4. Verfahren nach Anspruch 1, bei dem unter der Wirkung des Vorlade-Steuersignals (P) alle Eingänge (B, C) der Torschaltung (OG10, AG10) ausgenommen von einem deaktiviert sind und die Torschaltung in ein Übertragungs- oder Invertiergatter für den nicht deaktivierten Eingang (A) transformiert wird.

5. Verfahren nach Anspruch 4, umfassend einen Schritt unter der Wirkung des Vorlade-Steuersignals (P) des Kurzschließens von Transistoren (P2, P3, M12, M13) der Torschaltung (OG10, AG10), die in Serie geschaltet und durch die Eingänge (B, C) der Torschaltung ausgenommen von einem (A) gesteuert sind, und der Abschaltung von Transistoren (M2, M3, P12, P13), die parallel geschaltet und durch die Eingänge (B, C) der Torschaltung ausgenommen von einem (A) gesteuert sind.

6. Verfahren nach einem der Ansprüche 1 bis 5, bei dem die Torschaltung (OG1, OG2, AG1, AG2, OG10-OG12, AG10, AG11) ein Gatter des Typs UND, NICHT-UND, ODER oder NICHT-ODER ist.

7. Verfahren nach einem der Ansprüche 1 bis 6, bei dem jede der Torschaltungen (OG1, OG2, AG1, AG2, OG10-OG12, AG10, AG11, LG) der Logikschaltung, deren Betrieb nicht statistisch ausgeglichen ist, unter der Wirkung des Vorlade-Steuersignals (P) so modifiziert wird, dass das Ausgangssignal der Torschaltung in einem binären Zustand mit einer gleichen Wahrscheinlichkeit steht, wie die zufälligen am Eingang der Logikschaltung gelieferten Binärdaten.

8. Vorrichtung zur Gegenmaßnahme in einer Logikschaltung, umfassend eine Torschaltung (OG1, OG2, AG1, AG2, OG10-OG12, AG10, AG11, LG), die ein binäres Ausgangssignal (S) liefert,
**dadurch gekennzeichnet, dass** sie dafür konfiguriert ist, das Verfahren nach einem der Ansprüche 1 bis 7 einzusetzen.

9. Vorrichtung nach Anspruch 8, bei der die Torschaltung (AG1, AG2, LG) einen Multiplexer (MX, MX1, MX2) für jeden Eingang (I2, I3) der Torschaltung ausgenommen von einem (11) umfasst, dessen Ausgang mit dem Eingang der Torschaltung verbunden ist und welcher auf einem seiner Eingänge ein Eingangsdatum der Torschaltung empfängt, auf einem Steuereingang das Vorlade-Steuersignal (P), und auf einem anderen Eingang einen Erzwingungswert (x), der die Torschaltung in ein Übertragungs- oder Invertiergatter transformiert.

10. Vorrichtung nach Anspruch 8, bei der die Torschaltung (OG10, AG10) dafür konfiguriert ist, unter der Wirkung des Vorlade-Steuersignals (P) alle Eingänge (B, C) der Torschaltung ausgenommen von einem (A) zu deaktivieren und sich in ein Übertragungs- oder Invertiergatter für den nicht deaktivierten Eingang zu transformieren.

11. Vorrichtung nach Anspruch 10, bei der die Torschaltung Transistoren (P1-P3, M11-M13) umfasst, die am Ausgang (S) der Torschaltung in Serie geschaltet und jeweils durch einen Eingang (A, B, C) der Torschaltung gesteuert sind, Transistoren (M1-M3, P11-P13), die am Ausgang der Torschaltung parallel geschaltet und jeweils durch einen Eingang der Torschaltung gesteuert sind, einen durch das Vorlade-Steuersignal (P) gesteuerten Transistor (P4, M14), der alle in Serie geschalteten Transistoren ausgenommen von einem (P1, M11) kurzschließt, wenn das Vorlade-Steuersignal aktiviert ist, und einen durch das Vorlade-Steuersignal gesteuerten Transistor (M4, P14), der alle parallel geschalteten Transistoren ausgenommen von einem (M1, P11) abschaltet, wenn das Vorlade-Steuersignal aktiviert ist.

12. Vorrichtung nach einem der Ansprüche 8 bis 11, bei der die Torschaltung (OG1, OG2, AG1, AG2, OG10-OG12, AG10, AG11) ein Gatter des Typs UND, NICHT-UND, ODER oder NICHT-ODER ist.

13. Vorrichtung nach einem der Ansprüche 8 bis 12, bei der jede der Torschaltungen (OG1, OG2, AG1, AG2, OG10-OG12, AG10, AG11, LG) der Logikschaltung, deren Betrieb nicht statistisch ausgeglichen ist, unter der Wirkung des Vorlade-Steuersignals (P) so modifiziert wird, dass das Ausgangssignal der Torschaltung in einem binären Zustand mit einer gleichen Wahrscheinlichkeit steht, wie die zufälligen am Eingang der Logikschaltung gelieferten Binärdaten.

14. Elektronisches Bauelement, **dadurch gekennzeichnet, dass** es eine Vorrichtung zur Gegenmaßnahme nach einem der Ansprüche 8 bis 13 umfasst.

15. Tragbare Vorrichtung mit Mikroschaltung, **dadurch gekennzeichnet, dass** sie ein elektronisches Bauelement nach Anspruch 14 umfasst.
